# EUROPEAN PATENT APPLICATION

(11) **EP 4 779 336 A1**
(43) Date of publication of application: **22.07.2026**
(21) Application number: 24886399.5
(22) Date of filing: 04.11.2024
(51) Int. Cl.: G01R 31/385, G01R 31/392, H05B 1/02

(54) **CYCLING TEST DEVICE**

(30) Priority: 03.11.2023 KR 20230150493
(71) Applicant: LG Energy Solution, Ltd., Seoul 07335 (KR)
(72) Inventor: JANG, Eun Su, Daejeon 34122 (KR); CHOI, Jin Young, Daejeon 34122 (KR)
(74) Representative: Goddar, Heinz J.
(86) International application number: PCT/KR2024/017163
(87) International publication number: WO 2025/095729

(57) **Abstract**

The present invention relates to a test device for testing a performance of a battery, and more specifically, relates to a cycling test device for testing a performance of a battery by repeating charging and discharging of the battery within a constant temperature for a long period of time.

According to one example of the present invention, a cycling test device may be provided, which comprises: a first refrigerator having a cooling capacity for maintaining a temperature in a chamber at a constant temperature in consideration of a heat load in the chamber; a second refrigerator provided to be separated from the first refrigerator and having a cooling capacity greater than the cooling capacity of the first refrigerator, to lower the temperature in the chamber; and a control part controlling the second refrigerator to be selectively driven in cooling operation for lowering the temperature in the chamber.

## Description

### Technical Field

The present invention relates to a test device for testing a performance of a battery, and more specifically, relates to a cycling test device for testing a performance of a battery by repeating charging and discharging of the battery within a constant temperature for a long period of time.

### Background Art

Products such as batteries or semiconductor components may generate heat during operation. Therefore, after the product is manufactured, the product is tested in various environments, thereby verifying the performance of the product and whether it is a nondefective product.

Specifically, in the case of a battery, in which repeated charging and discharging are required, such as a secondary battery, it is possible to test the battery by disposing the battery in a predetermined space, and then charging and discharging it under a constant temperature condition for a long period of time. Here, the constant temperature may be the room temperature at which the battery is used, and the performance of the battery at a very low temperature or a very high temperature, as one example of a harsher temperature condition, may also be tested.

Meanwhile, a test of a battery through a cycling test device may also be performed for verifying or identifying not only the performance of the completely manufactured battery, but also the performance of the battery during a design process of the battery.

Generally, the test of the battery through a cycling test device is performed for a long period of time, usually several months or longer. Uses, forms, shapes, sizes, characteristics, and materials of the battery, and the like can be designed very diversely depending on applications to which the battery is applied. Therefore, a great variety of batteries must be designed according to demanders' requirements, and accordingly, a great variety of cycling test devices are required.

Generally, the cycling test device is provided to perform constant temperature operation maintaining constantly a temperature in a chamber having a test space where a battery is accommodated. As the battery is repeatedly charged and discharged, heat generation may occur, so that the cycling test device has a temperature adjustment part such as a refrigerator. In addition, the cycling test device comprises a heater, and the like.

The cycling test device can be classified into a room temperature device, a low temperature device, and a high-performance device depending on test conditions. The room temperature device can be provided for testing between room temperature and high temperature, the low temperature device can be provided for testing between approximately -40°C or less to a high temperature region (+89°C), and the high-performance device can be provided for testing that high-performance cooling and heating rates of 3 to 4°C or so per minute are required. Among these, the room temperature device is most used, and specifications of a refrigerator including a compressor and a heater including can be determined for each device according to the required performance.

The temperature adjustment part comprises a compressor compressing a refrigerant, where the constant temperature operation can be performed not only at room temperature but also at low temperature, so that a compressor having a cooling capacity greater than a cooling capacity required to remove heat generated during the battery test is generally provided. Therefore, the cooling capacity greater than the heat removal capacity required for the constant temperature operation is used, so that a heater for heating the supercooled air can be constantly driven.

Currently, in the case of the room-temperature cycling test device as most used, a compressor of 1/2 horsepower (HP) to 5 horsepower (HP) is applied depending on the specifications of the chamber interior space. That is, as compressors with lower output compared to compressors for refrigerators as industrially used widely are used, there is a limitation in the compressor output control (as one example, inverter control) method, so that as most low-capacity compressors, compressors driven in a constant speed type are used. However, as the specifications of the battery increase and cell areas increase, the output of the compressor tends to increase. Then, the specifications of the compressor are reflected, whereby a resistance heating heater of 2 to 15 kW is applied.

As described above, a constant-speed compressor is generally used in the cycling test device, so that heat removal occurs regardless of a heat load generated inside the chamber, by the capacity of the compressor. In many cases, the heat quantity removed through the compressor is greater than the heat load. Therefore, the supercooled amount is compensated by driving the heater as much as the supercooled, thereby maintaining the temperature inside the chamber constant. In other words, it can be regarded that unnecessary energy is consumed due to supercooling and heater driving. Particularly, the heat removed by supercooling is released outside the chamber in the form of heat generation from a condenser of the refrigerator, which increases a heat removal load of the chamber, whereby the capacity of the additional heat removal system for chamber heat removal increases and the energy consumption required for heat removal increases. Therefore, the heat energy removed unnecessarily in an amount of a certain amount or more upon the constant temperature operation maintaining a constant temperature for a long time, and the energy consumed by supercooling are minimized, whereby it is necessary to improve energy efficiency. Then, an excessive temperature deviation may occur within the cycling test device due to energy loss occurring in the cycling test device. Therefore, it is not easy to perform efficient and accurate constant temperature operation.

As described above, makers for designing and manufacturing batteries require a lot of cycling test devices. This is because requirements for new batteries are very high depending on the application of the battery. Therefore, it can be regarded that as the types and quantities of cycling test devices increase, energy efficiency improvement of the devices becomes an essential requirement.

In addition, multiple cycling test devices are provided in a very large test room, where the heat energy emitted from the individual cycling test devices may cause a heat island phenomenon in the test room. Due to such a heat island phenomenon, it is not easy to operate the test room, and the energy efficiency of the individual cycling test devices inevitably deteriorates.

Therefore, it is necessary to find a way to improve the energy efficiency of the entire test facility including the test room as well as the energy efficiency of the individual cycling test devices.

### Disclosure

### Technical Problem

The present invention is basically intended to solve problems of the conventional cycling test devices.

Through one example of the present invention, it is intended to provide a cycling test device capable of improving energy efficiency by separately operating a refrigerator for constant temperature operation and a refrigerator for cooling operation.

Through one example of the present invention, it is intended to provide a cycling test device capable of minimizing a heat island phenomenon in a test room by minimizing a heat quantity emitted from the cycling test device.

### Technical Solution

In order to achieve the above-described objects, according to one example of the present invention, a cycling test device providing constant temperature operation for maintaining a temperature in a chamber at a constant temperature and cooling operation for lowering the temperature in the chamber may be provided, in which the cycling test device is characterized by comprising: a first temperature adjustment part driven upon the constant temperature operation; and a second temperature adjustment part driven upon the cooling operation, wherein a cooling capacity of the second temperature adjustment part is greater than a cooling capacity of the first temperature adjustment part.

The cycling test device may be provided so that the constant temperature operation is performed as basic operation. That is, the temperature in the chamber may be set, and the constant temperature operation continuously maintaining the set temperature may be performed. This constant temperature operation may be continuously performed for a very long period.

The cycling test device may be provided for testing a performance of a secondary battery. It is possible to test safety and the performance of the battery can be tested by repeating charging and discharging. Particularly, it is possible to test the battery at a temperature at which it is used, as one example, at room temperature for a long time, where the constant temperature operation may be performed to continuously maintain the room temperature.

Meanwhile, the battery may also be used by being exposed to a very low temperature environment or a high temperature environment. Therefore, the performance of the battery may also be tested in a state where a specific low temperature or a specific high temperature is maintained. That is, the constant temperature operation may be performed not only at room temperature but also at a specific low temperature or a specific high temperature.

Here, if the temperature condition for constant temperature operation is lower than the current temperature, the test device may perform cooling operation. Conversely, if the temperature condition for constant temperature operation is higher than the current temperature, the test device may perform temperature increase operation. The cooling operation may be transitional operation performed in the process of lowering the temperature in the chamber to a newly set low temperature, and the temperature increase operation may be transitional operation performed in the process of raising the temperature in the chamber to a newly set high temperature. Therefore, the constant temperature operation may be performed when the cooling operation or temperature increase operation is finished.

It is preferable that the first temperature adjustment part comprises a first refrigerator provided to adjust a temperature of the supplied air, and the second temperature adjustment part comprises a second refrigerator provided to adjust a temperature of the supplied air and having a cooling capacity greater than a cooling capacity of the first refrigerator.

The first refrigerator and the second refrigerator may comprise compressors distinct from each other, respectively. In addition, the first refrigerator and the second refrigerator may comprise evaporators distinct from each other, respectively. That is, it is preferable that the first refrigerator and the second refrigerator are provided so that different cooling cycles are individually driven.

It is preferable that a refrigerant compression capacity of the compressor (second compressor) in the second refrigerator is greater than the refrigerant compression capacity of the compressor (first compressor) in the first refrigerator. That is, when performing heat removal by driving the cooling cycles, it is preferable that the heat removal capacity of the second compressor is greater than the heat removal capacity of the first compressor.

The chamber may comprise a housing having a first case forming a plurality of partition walls forming a test space for accommodating a battery and conducting a test, and a second case partitioned from the first case.

It is preferable that a circulation duct, in which air discharged from the test space is resupplied to the test space, is provided between the first case and the second case.

It is preferable that the circulation duct is provided with the evaporator (first evaporator) of the first refrigerator and the evaporator (second evaporator) of the second refrigerator, respectively. That is, when the cooling cycle of the first refrigerator is driven, the refrigerant may be supplied to the first evaporator and recovered, and when the cooling cycle of the second refrigerator is driven, the refrigerant may be supplied to the second evaporator and recovered. A refrigerant pipe through which the refrigerant of the first refrigerator flows may be provided to be separated from a refrigerant pipe through which the refrigerant of the second refrigerator flows.

It is preferable that the evaporator of the first refrigerator, and the evaporator of the second refrigerator are sequentially disposed side by side in the flow direction of air. That is, the air passing through the first evaporator may pass through the second evaporator or vice versa.

In the case of a cooling cycle cooling the circulating air, heat exchange absorbing heat from the circulating air is performed, and heat exchange discharging heat to the surrounding air is performed. Therefore, as the absorbed heat quantity increases, the discharged heat quantity also inevitably increases. That is, the matter of absorbing heat beyond necessity means the matter of conversely discharging heat beyond necessity.

The first temperature adjustment part, especially the first refrigerator, may be provided to be driven in the constant temperature operation. That is, it may be provided to exert only a cooling performance to the extent that a heat load is calculated by including a heat value generated in the chamber and some margins, and the calculated heat load is removed. Particularly, it is preferable that the compressor of the first refrigerator is a constant speed compressor, which minimizes the heat quantity generated by the compressor itself by having a capacity enough to remove the heat load. This means that it is possible to prevent supercooling from occurring as the compressor is driven, and means as well that it is possible to prevent the heater from being driven unnecessarily to compensate for the temperature when supercooling occurs.

The cycling test device may provide temperature increase operation for raising the temperature in the chamber, and comprise a heater driven upon the temperature increase operation. That is, the heater is basically provided for the temperature increase operation, which may exclude or minimize driving upon the constant temperature operation.

The heater may be provided on the downstream side of the first evaporator and the second evaporator in the circulation duct. That is, the air passing through the evaporators may be heat-exchanged with the heater, and then supplied into the chamber.

It is preferable that a fan for supplying the air heat-exchanged through the first evaporator, the second evaporator, and the heater to the inside of the chamber is provided. As the fan is driven, air circulation may occur.

The fan may be provided in the upstream of the evaporator or the downstream of the heater, or may be provided in both upstream and downstream. Therefore, at least one fan may be provided.

It is preferable that at least one temperature sensor for measuring the temperature in the chamber; and a control part controlling drive of the first temperature adjustment part, the second temperature adjustment part, and the heater based on the set temperature and the temperature in the chamber are provided.

The control part may be provided to control implementation of constant temperature operation, cooling operation, and temperature increase operation.

The control part may control the constant temperature operation for continuously maintaining the set temperature to be performed as the basic operation. That is, the test device basically performs the constant temperature operation maintaining the set temperature.

The control part may control the constant temperature operation to be performed after the cooling operation upon decrease of the set temperature. Then, the control part may control the constant temperature operation to be performed after the temperature increase operation upon increase of the set temperature.

The cooling operation and the temperature increase operation may be referred to as transitional operation from the constant temperature operation based on the current set temperature to the constant temperature operation based on the changed set temperature.

In the constant temperature operation, the driving of the heater may be excluded or minimized.

It is preferable that the compressor of the second refrigerator is driven only upon the cooling operation.

The compressor of the first refrigerator may also be driven upon the cooling operation. Through this, the new set temperature may be reached more quickly.

In order to achieve the above-described objects, according to one example of the present invention, a cycling test device providing constant temperature operation for maintaining temperatures in a plurality of chambers, respectively, at a constant temperature and cooling operation for lowering temperatures in a plurality of chambers, respectively, characterized by comprising a plurality of first temperature adjustment parts driven upon the constant temperature operation for maintaining the temperatures in the chambers at a constant temperature and provided to correspond to the plurality of chambers, respectively; a second temperature adjustment part driven upon the cooling operation for lowering the temperature in the chambers and provided corresponding to the plurality of chambers, wherein a cooling capacity of the second temperature adjustment part is greater than a cooling capacity of the first temperature adjustment part.

Here, it is preferable that only any one of the plurality of chambers is provided to enable the cooling operation to be performed.

When the cooling operation is required in two or more chambers of the plurality of chambers, the cooling operation may be performed sequentially. That is, when the cooling operation is performed and terminated in one chamber, the cooling operation may be performed in another chamber thereafter.

The first temperature adjustment part may comprise a plurality of first refrigerators provided to correspond to each of the plurality of chambers, respectively, so that the temperature of the supplied air is adjusted.

The second temperature adjustment part may comprise a single second refrigerator provided to adjust the temperature of the supplied air, having a cooling capacity greater than a cooling capacity of the first refrigerator, and provided to correspond to all the plurality of chambers. That is, if the first refrigerator and the chamber are in a one-to-one correspondence relationship, the second refrigerator and the chamber may be in a one-to-many correspondence relationship.

It is preferable that the second temperature adjustment part comprises a plurality of second evaporators connected in parallel with the single second refrigerator and provided to correspond to the plurality of chambers, respectively. That is, it is preferable that the second evaporators, among components of the second refrigerator, are provided to be in a one-to-many correspondence relationship with the chambers.

Meanwhile, if a plurality of chambers is provided, second refrigerators may also be provided individually for each chamber.

In order to achieve the above-described objects, according to one example of the present invention, a cycling test device may be provided, which comprises: a first refrigerator having a cooling capacity for maintaining a temperature in a chamber at a constant temperature in consideration of a heat load in the chamber; a second refrigerator provided to be separated from the first refrigerator and having a cooling capacity greater than the cooling capacity of the first refrigerator, to lower the temperature in the chamber; and a control part controlling the first refrigerator to be driven in constant temperature operation for maintaining the temperature in the chamber at the constant temperature, and controlling the second refrigerator to be driven only in cooling operation for lowering the temperature in the chamber.

The cooling operation may be performed when the current temperature in the chamber increases above a control range during the constant temperature operation. This may be caused by a change in the set temperature or a sudden change in the heat load in the chamber.

If the cooling operation is performed, and the temperature in the chamber reaches the target temperature, the cooling operation may be terminated and the constant temperature operation may be performed. In the constant temperature operation, the temperature in the chamber may vary within the set range.

The first refrigerator and the second refrigerator may each comprise a refrigerant cycle in which a refrigerant circulates and a refrigerant pipe performing the same, and may each comprise a compressor, a condenser, and an evaporator. In addition, it may comprise an expansion valve for expanding the refrigerant between the condenser and the evaporator.

Specifically, it is preferable that the first refrigerator and the second refrigerator comprise compressors and evaporators, which are separated from each other, respectively, and a refrigerant compression capacity of the compressor (first compressor) in the first refrigerator is greater than a refrigerant compression capacity of the compressor (second compressor) in the second refrigerator.

The chamber may comprise a test space for accommodating and testing a battery, and a circulation duct in which the air discharged from the test space is resupplied to the test space may be provided.

The evaporator (first evaporator) of the first refrigerator and the evaporator (second evaporator) of the second refrigerator may each be provided in the circulation duct.

The first evaporator and the second evaporator may be sequentially disposed side by side in the flow direction of air. It is preferable that the first evaporator and the second evaporator are disposed so that the air passing through the first evaporator passes through the second evaporator.

It is preferable that it comprises one or more temperature sensors for measuring a temperature in the test space, wherein the control part controls driving of the first refrigerator and the second refrigerator by distinguishing the constant temperature operation and the cooling operation based on the set temperature and the temperature sensed by the temperature sensor.

The constant temperature operation is operation for maintaining the set temperature. After the temperature in the chamber reaches the initially set temperature, the operation for maintaining the same can be referred to as the constant temperature operation.

It is preferable that the control part controls the second refrigerator to be driven only in the cooling operation. The cooling operation may be performed when the set temperature is lowered during the constant temperature operation, and may be performed when the temperature inside the chamber increases for an unexpected reason during the constant temperature operation, as one example, when it goes out of the control range of the constant temperature operation.

The control part may control the first refrigerator to be driven constantly or to be driven when the temperature in the chamber reaches the set temperature for performing the constant temperature operation.

In the constant temperature operation, driving of a heater provided so that an output is changed by receiving feedback of the temperature in the chamber may be controlled.

The first compressor may be provided with a constant speed compressor having a compression capacity of 1/2 HP or less, and the second compressor may be provided with a constant speed compressor or an inverter-controlled compressor having a compression capacity of 2 HP or more. As one example, when the compressor of 2 HP or more is provided and constantly operated, more heat removal is always performed than the required heat removal amount, and accordingly, the output of the heater becomes higher than necessary. As a result, the energy consumed by the compressor and the energy consumed by the heater inevitably increase.

On the other hand, through the constant speed compressor of 1/2 HP or less, the energy consumed by the compressor and the energy consumed by the heater may be significantly reduced upon constant operation. Of course, by operating a high-capacity compressor of 2 HP or more only upon the cooling operation, which is a limited condition, the cooling capacity required by the cycling test device may be satisfied.

In order to achieve the above-described objects, according to one example of the present invention, a cycling test device providing constant temperature operation for maintaining temperatures in a plurality of chambers, respectively, at a constant temperature and cooling operation for lowering temperatures in a plurality of chambers, respectively, may be provided, which is characterized by comprising: a plurality of first refrigerators driven upon the constant temperature operation for maintaining the temperature in the chamber at a constant temperature and provided to correspond to the plurality of chambers, respectively; and a single second refrigerator driven upon the cooling operation for lowering the temperature in the chamber and provided to correspond to the plurality of chambers, wherein a cooling capacity of the second refrigerator is greater than a cooling capacity of the first refrigerator.

A space where a test is performed, i.e., a chamber, may be divided in a single cycling test device, and a target temperature may be set independently for each chamber.

Only any one of the plurality of chambers may be provided to enable the cooling operation to be performed.

When the cooling operation is required in two or more chambers of the plurality of chambers, the cooling operation may be performed sequentially.

The second refrigerator may comprise a plurality of second evaporators connected in parallel with the single second refrigerator and provided to correspond to the plurality of chambers, respectively, and the second evaporators may be disposed sequentially to correspond one-to-one with evaporators of the first refrigerators.

The control part may control the plurality of first refrigerators to be driven independently, and may control driving of the second refrigerator when the driving of the second refrigerator is required, but control a cooling performance of the second refrigerator to be variable. As one example, when the compressor of the second refrigerator is an inverter compressor, it is possible to variably control the cooling performance by distinguishing a case where the cooling operation is performed in one chamber from a case where the cooling operation is performed in multiple chambers.

The compressor of the second refrigerator is provided as a single compressor, and it is also possible to selectively block the refrigerant flowing into the evaporator of the second refrigerator provided in each chamber. As one example, the refrigerant may be supplied only to the evaporator connected to the chamber where the cooling operation is performed, and the supply of the refrigerant to the evaporator connected to the chamber where the constant temperature operation is performed may be blocked.

### Advantageous Effects

Through one example of the present invention, it is possible to provide a cycling test device capable of improving energy efficiency by separately operating a refrigerator for constant temperature operation and a refrigerator for cooling operation.

Through one example of the present invention, it is possible to provide a cycling test device capable of minimizing a heat island phenomenon in a test room by minimizing a heat quantity emitted from the cycling test device.

Through one example of the present invention, the performance of the refrigerator required for always-on running can be minimized within the range capable of treating the heat load within the chamber. Therefore, energy inefficiently wasted in always-on running, i.e. constant temperature operation, can be significantly reduced. In other words, waste of energy for driving the refrigerator can be reduced.

Through one example of the present invention, in a test chamber where long-term temperature maintenance is performed, a low-capacity first refrigerator is driven under a temperature maintenance condition as constantly operated (constant temperature operation), and a high-capacity second refrigerator is driven only under a temporary temperature change condition (cooling operation), whereby it is possible to significantly reduce the energy consumed in the test chamber.

### Description of Drawings

Figure 1 illustrates a schematic cross-section of a cycling test device according to one example of the present invention, and
Figure 2 illustrates an outer shape of a cycling test device according to one example of the present invention.
Figure 3 is a control configuration diagram of a cycling test device according to one example of the present invention, and

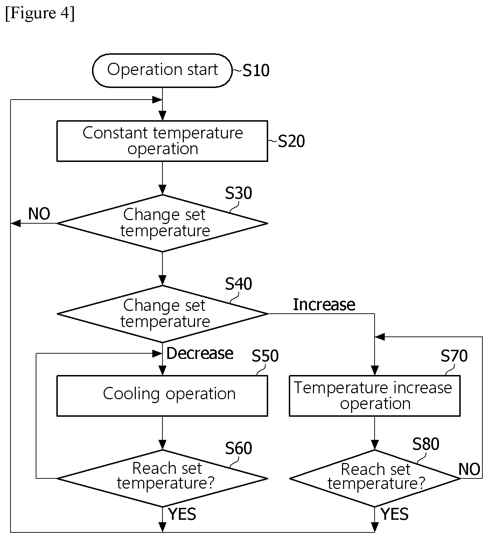

Figure 4 is a control flow diagram of a cycling test device according to one example of the present invention.

### Best Mode

Hereinafter, a cycling test device according to one example of the present invention will be described in detail with reference to the attached drawings.

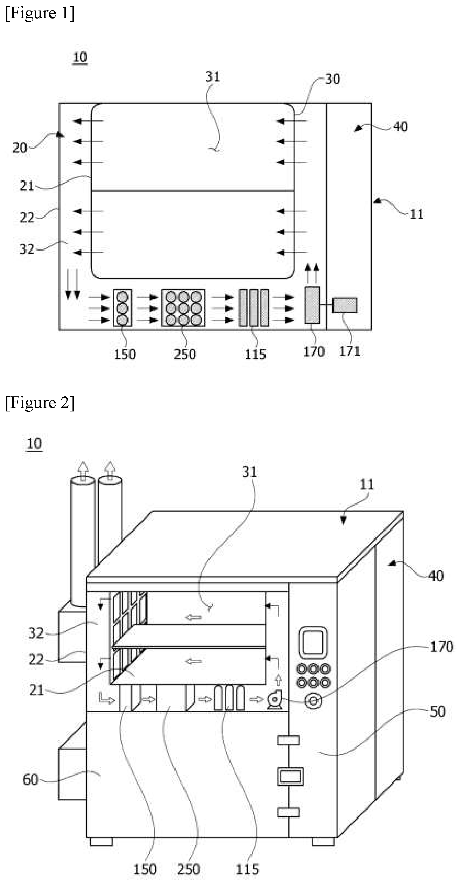

Hereinafter, a test device according to one example of the present invention will be described in detail with reference to Figures 1 and 2.

Figure 1 schematically illustrates a cross-section of a cycling test device according to one example of the present invention, and Figure 2 schematically illustrates an outer shape of the cycling test device.

The test device (10) may comprise a cabinet (11) forming an outer shape. The cabinet (11) may be provided with a housing (20) forming a chamber (30) and a machine room (40) in which components forming refrigerators are provided, which are separated from each other.

A control panel (50) may be provided on the front surface of the cabinet (11). The control panel (50) may be provided with an operating part capable of inputting temperature conditions or time conditions within the chamber, and a display part capable of displaying the current state.

The housing (20) may comprise a chamber (30) having a test space (31) therein. Then, it may comprise a circulation duct (32) surrounding at least three sides of the chamber (30). As one example, the air discharged to one side surfac of the chamber may move to the rear of the chamber, and then may be supplied to the inside of the chamber through the other side of the chamber. That is, air circulation may be performed.

A plurality of chambers (30) may be provided in one test device (10), and as one example, a device in which two chambers are provided is shown in Figure 2.

In the test space (31), various types of battery performance tests such as a battery charging and discharging test may be performed.

Specifically, the housing (20) may comprise a first case (21) forming a plurality of partition walls forming the test space (31), and a second case (22) partitioned from the first case (21).

The first case (21) may be provided to have upper, lower, left, right, and rear walls except for the front surface connected to the outside through a door (60).

The circulation duct (32) may be provided or formed between the first case (21) and the second case (22). As illustrated, air in the chamber may be discharged to one side wall of the first case (21) to flow into the rearward of the first case (21) or the bottom of the first case (21), and then the air may flow into the inside of the chamber through the other side wall of the first case (21). A plurality of through-holes may be formed in one side wall and the other side wall of the first case (21) to be capable of inflow and outflow of air.

Battery testing may be performed for a very long period, and the start and end of a specific battery test are usually performed in the same chamber (30). This is because input and output factors in the battery test process are very sensitive, so that the precision of these factors may be damaged as the chamber (30) is changed. For this reason, it can be regarded that a very large number of test devices (10) are required when the types or numbers of batteries to be tested are various.

During the battery test process, heat may be generated in the battery. The battery test process is generally performed at a constant temperature for a long time. Therefore, to maintain a constant temperature, a temperature adjustment part for controlling the temperature inside the chamber (30) is required.

This temperature control may be performed through the air circulating through the circulation duct (32). Such a temperature control method may be referred to as a convection type. Specifically, a heat exchanger is provided in the circulation duct (32) to absorb heat from the air. That is, the heat generated in the chamber may be removed through the heat exchanger in the circulation duct (32).

It is preferable that the circulation duct (32) is provided for each chamber.

As illustrated, different heat exchangers may be disposed side by side in the circulation duct (32). As one example, the air discharged in the chamber may be heat-exchanged while passing through the first heat exchanger (150) and the second heat exchanger (250) sequentially. Here, the heat exchanger may be a part of the components forming the refrigeration cycle, and the first heat exchanger (150) and the second heat exchanger (250) may be components forming refrigeration cycles distinct from each other. In terms of the refrigerant, these heat exchangers may be referred to as evaporators. That is, the liquid refrigerant flowing into the evaporator absorbs heat from the surrounding air and changes into a gaseous refrigerant.

Here, the first heat exchanger (150) may be a partial component of the first temperature adjustment part or the first refrigerator to be described below, and the second heat exchanger

(250) may be referred to as a partial component of the second temperature adjustment part or the second refrigerator to be described below.

In addition, the circulation duct (32) may be provided with a heater (115). The heater may be provided to intentionally increase the temperature in the chamber. Of course, by supplying heat upon supercooling, the heater (115) may be provided, to compensate for the supercooling with appropriate cooling.

A circulation fan (170) may be provided for air circulation of the circulation duct (32). The fan may be provided in the form of a sirocco fan sucking and discharging air, and when the fan is operated, air inside the chamber may be sucked and the air may be discharged back into the chamber. A motor (171) operating the circulation fan (170) may be provided in the machine room (40) rather than the inside of the circulation duct (32).

Hereinafter, the first temperature adjustment part and the second temperature adjustment part which are applicable to the test device according to one example of the present invention will be described in more detail.

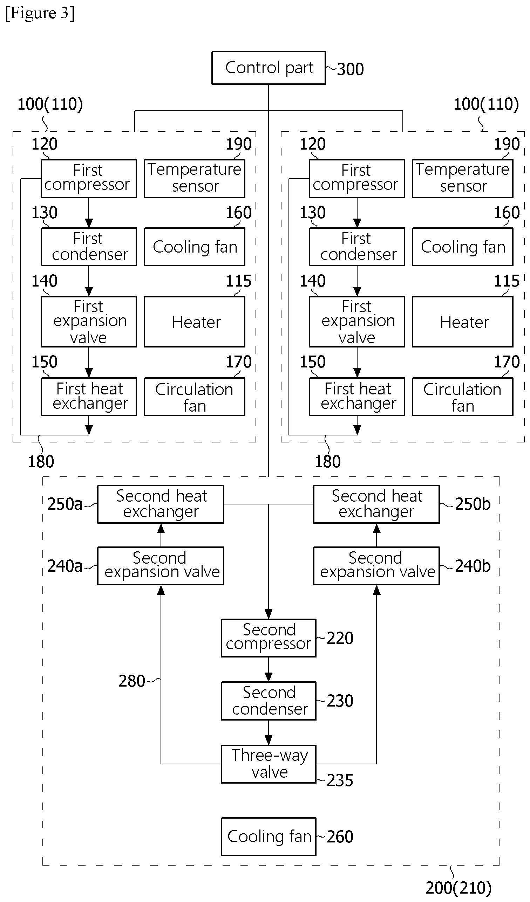

As shown in Figure 3, the test device may comprise a first temperature adjustment part (100) and a second temperature adjustment part (200). The test device may comprise a plurality of chambers, where the temperature adjustment parts are individually provided for each chamber, so that temperature control may be performed individually. That is, in the case of a plurality of chambers, a plurality of first temperature adjustment parts (100) may also be provided. Figure 2 illustrates one example in which on the premise of two chambers, two first temperature adjustment parts (100) are provided.

The first temperature adjustment part (100) may comprise a first refrigerator (110) that heat in the air flowing into the chamber is absorbed to cool it. That is, it may comprise a first refrigerator (110) capable of performing the cooling cycle.

The first refrigerator (110) may comprise a first compressor (120) compressing a refrigerant, a first condenser (130) varying a high-temperature gaseous refrigerant into a liquid refrigerant, a first expansion valve (140) expanding a refrigerant, and a first heat exchanger (150) performing heat exchange in which it is converted into a low-temperature, low-pressure gaseous refrigerant. In addition, the first refrigerator (110) may comprise a refrigerant pipe (180) providing a passage through which a refrigerant moves by connecting the components.

The first refrigerator (110) performs a cooling cycle using a refrigerant, thereby performing heat removal, where a cooling capacity, a freezing capacity, or a heat removal capacity is determined. Particularly, the capacity of the first refrigerator (110) may be determined by the capacity or performance of the first compressor (120).

Meanwhile, the first refrigerator (110) may comprise a fan (170), and may comprise a cooling fan (160) for cooling the first condenser by supplying ambient air to the first condenser

(130). Since air circulation occurs through the fan (170), it may also be referred to as a circulation fan.

The first temperature adjustment part (100) may further comprise a heater (115). In other words, to adjust the temperature in the chamber, the cooling component may be referred to as the first refrigerator (110), and the heating component may be referred to as the heater (115).

The components of the first temperature adjustment part (100) in the test device according to one example of the present invention may be the same as the components of the temperature adjustment part in the conventional test device. However, both devices have differences in various aspects such as the freezing capacity, the operation time, and interlocking with the heater.

The first refrigerator (110) may basically have a cooling capacity necessary for optimal heat removal to maintain the temperature of the chamber. In other words, it may have the optimal cooling capacity for constant temperature operation. This means that the first refrigerator (110) does not need an additional cooling capacity capable of performing not only constant temperature operation but also cooling operation.

As one example, the operation of the test device may comprise constant temperature operation, cooling operation, and temperature increase operation. The constant temperature operation may be operation for maintaining the temperature in the chamber at a set temperature, the cooling operation may be operation temporarily performed when the set temperature is changed to a temperature lower than the current temperature, and the temperature increase operation may be referred to as operation temporarily performed when the set temperature is changed to a temperature higher than the current temperature. Then, when a new set temperature is reached through the cooling operation and temperature increase operation, the constant temperature operation for maintaining the new set temperature again may be performed.

It can be regarded that such a test device is operated for a very long time and basically performs constant temperature operation, and the cooling operation or temperature increase operation is performed very limitedly and temporarily.

Upon performing the constant temperature operation, a cooling capacity to the extent capable of removing a heat load is required to maintain the temperature inside the chamber, but upon performing the cooling operation, a larger cooling capacity is required because the temperature inside the chamber must be lowered.

In the conventional test device, a temperature controller or refrigerator with a relatively large cooling capacity was used in consideration of cooling operation. That is, the cooling capacity was determined considering even the limited cooling operation, whereby there was a problem that supercooling was performed upon the constant temperature operation. Particularly, to resolve the supercooling, the heater was unnecessarily driven, whereby the unnecessary energy consumption generated from the refrigerator and the heater operation energy consumption were the cause of energy efficiency reduction. Of course, this excessive energy also caused a problem of increasing the temperature around the test device.

According to one example of the present invention, the first temperature adjustment part (100) or the first refrigerator (110) may have the cooling capacity required for constant temperature operation, and upon cooling operation, the second temperature adjustment part (200) or the second refrigerator (210) provided separately from the first temperature adjustment part (100) or the first refrigerator (110) may have the required cooling capacity.

That is, upon constant temperature operation, which is the main operation of the test device, the first temperature adjustment part (100) enables to be driven, and upon cooling operation, which is the very limited auxiliary operation of the test device, the second temperature adjustment part (200) enables to be driven. Here, it is preferable that the cooling capacity of the second temperature adjustment part is greater than the cooling capacity of the first temperature adjustment part. Therefore, since the driving of the second temperature adjustment part (200) with a large cooling capacity is restricted upon constant temperature operation, energy consumption can be significantly reduced.

Meanwhile, the test device according to one example of the present invention may comprise a plurality of chambers. As one example, if two chambers are provided, two first temperature adjustment parts (100) may be provided. It is preferable that the two first temperature adjustment parts (100) are provided individually from each other and are driven individually from each other. This means that two first refrigerators (110) are also provided and driven individually from each other. As the number of chambers increases, the first temperature adjustment parts (100) may be provided in the same number as the number of chambers.

The test device according to one example of the present invention may comprise a second temperature adjustment part (200) or a second refrigerator (210). The components forming the second temperature adjustment part (200) or the second refrigerator (210) may be like the components forming the first temperature adjustment part (100) or the first refrigerator (110) as described above.

The second refrigerator (210) may comprise components forming a cooling cycle. Specifically, it may comprise a second compressor (220), a second condenser (230), a second expansion valve (240), a second heat exchanger (250), and a refrigerant pipe (280). The respective functions of these components may be regarded to be the same as those of the first refrigerator.

The refrigerator comprises a compressor, and the cooling capacity of the refrigerator is generally implemented through the refrigerant compression capacity of the compressor.

It is preferable that the refrigerant compression capacity of the second compressor (220) in the second refrigerator (210) is larger than the refrigerant compression capacity of the first compressor (120) in the first refrigerator (110). That is, it is preferable that the specifications of the second compressor (220) are larger than the specifications of the first compressor (120).

A first compressor (120) having a performance corresponding to the heat removal capacity upon basic and main constant temperature operation may be selected.

As one example, a first compressor with a specification of 1/2 HP may be applied in a room temperature test device which is usable in a room temperature to high temperature environment. Compared to the fact that in a conventional room temperature test device with the same conditions, a compressor of 1 to 3 HP was used, a compressor with a much lower specification may be applied in the present example. Therefore, the waste of energy corresponding to 1/2 to 5/2 HP can be reduced upon constant temperature operation.

Meanwhile, the specifications of the conventional compressor were determined in consideration of cooling operation. As one example, a 3 HP compressor exhibited the 3 HP performance upon cooling operation, and performed sufficient cooling. However, in the case of a constant speed compressor, it cannot help but exhibit the 3 HP performance even in the constant temperature operation that only 1/2 HP performance is required.

On the other hand, according to the present example, a second compressor (220) is separately provided for cooling operation, so that the wasted energy can be significantly reduced. This is because the cooling operation is performed in a very limited and short time, whereas the constant temperature operation is performed for a very long time.

According to the present example, even if a single test device is provided with multiple chambers, it is preferable that a single second refrigerator (210) is provided. However, among the detailed components of the second refrigerator (210), it is preferable that the second heat exchanger (250) is provided in the same number as the number of chambers.

In the case where two chambers are provided, the second heat exchanger (250) may comprise two heat exchangers (250a, 250b) distinct from each other. Then, the second expansion valve (240) may comprise two expansion valves (240a, 240b) corresponding thereto.

Here, it is preferable that the respective second heat exchangers (250a, 250b) are individually provided in a circulation duct near the relevant chambers. As one example, it is preferable that when the cooling operation is performed in the first chamber, the refrigerant is controlled to flow into a specific second heat exchanger (250a), and when the cooling operation is performed in the second chamber, the refrigerant is controlled to flow into another second heat exchanger (250b).

It is preferable that the second heat exchanger (250) is provided on the downstream side of the first heat exchanger (150). In the case of cooling operation, the cooling through the first heat exchanger (150) as well as the cooling by the second heat exchanger (250) may be performed simultaneously. In this case, it is preferable that the cooling is first performed through the first heat exchanger (150) having a small cooling capacity, and then the cooling is performed through the second heat exchanger (250) having a large cooling capacity.

The refrigerant flowing through one second compressor (220) and the second condenser (230) enables to be selectively introduced into the second heat exchangers (250a, 250b) provided in parallel with each other. To this end, a passage switching valve, as one example, a three-way valve (235) may be provided.

The second refrigerator (210) may comprise a cooling fan (260) for cooling the second condenser (230).

As described above, the maximum cooling capacity through the first compressor (120) and the second compressor (220) is determined by the specifications of the compressors. Therefore, as the first compressor and the second compressor are driven, supercooling may occur in the current temperature control process. Therefore, it is preferable to control so that only the necessary heat quantity can be removed.

The control part (300) controls the operation of the first temperature adjustment part (100) and the second temperature adjustment part (200), which may perform, particularly, the operation control based on the sensing temperature of at least one temperature sensor (190).

The temperature sensor (190) may be provided to sense the temperature inside the chamber, or may be provided to sense the temperature of air flowing into the chamber. Of course, the temperature sensor may also be provided in a plurality of sensors per chamber.

The heat load inside the chamber may also vary depending on the maintaining temperature inside the chamber. Therefore, it is preferable that a heat removal quantity (heat duty) may be adjusted depending on the heat load.

First, among the components of the first temperature adjustment part (100), the first expansion valve (140) is configured as a temperature automatic expansion valve, and an opening rate of the valve is controlled depending on the temperature maintenance conditions of the chamber, whereby it is ultimately possible to control the heat removal quantity through the first heat exchanger (150). Of course, a manual expansion valve capable of manually adjusting the opening rate of the valve may also be applied. The characteristics of such an expansion valve may be equally applied to the second temperature adjustment part (200).

Hereinafter, with reference to Figure 3, a control method of a cycling test device according to one example of the present invention will be described in detail.

When the test device starts operation (S10), the constant temperature operation (S20) basically maintaining the set temperature may be performed. That is, the operation for maintaining the temperature in the chamber at the set temperature may be performed.

It is preferable that the constant temperature operation (S20) is performed for a very long period if the set temperature conditions are not changed. In the constant temperature operation, the battery is tested for its performance or safety, and the like while repeating charging and discharging. Then, in this constant temperature operation (S20), the first temperature adjustment part (100) is driven and the driving of the second temperature adjustment part (200) is excluded.

During the constant temperature operation, the set temperature may be changed, and when this change in the set temperature is sensed (S30), it may be determined whether the set temperature increases or decreases (S40), and depending on the determination result, the cooling operation or the temperature increase operation may be performed.

If the new set temperature is set lower than the current set temperature, the cooling operation may be performed (S50). Since the first temperature adjustment part (100) has only the capacity for removing the heat load of the chamber, sufficient cooling may be difficult with the cooling capacity of the first temperature adjustment part. Even if the maximum cooling is performed through the first temperature adjustment part (100), it may take a long time to reach the new set temperature. Therefore, it is preferable that when the cooling operation starts, the second temperature adjustment part (200) is driven.

At this time, for faster cooling, the first temperature adjustment part (100) may also be driven together with the second temperature adjustment part (200).

A new set temperature is reached through the cooling operation (S60), and then the constant temperature operation based on the new set temperature may be performed again. Therefore, the cooling operation may be referred to as transitional operation temporarily performed between the constant temperature operation and the constant temperature operation, so that the cooling operation time can only be a very small portion of the entire device's operating time.

The new set temperature is set higher than the current set temperature, and the temperature increase operation may be performed (S70). The first temperature adjustment part (100) drives the heater (115) for temperature-raising. The temperature increase operation increasing the temperature of air may be performed by adding the heat quantity of the heater together with the heat load of the chamber. Of course, it is preferable that the driving of the second temperature adjustment part (200) is excluded from the temperature increase operation. Furthermore, it is preferable that the fan (170) of the first temperature adjustment part (100) is driven for air circulation.

Through the temperature increase operation, a new set temperature is reached (S80), and then the constant temperature operation based on the new set temperature may be performed again. Therefore, the temperature increase operation may be referred to as transitional operation temporarily performed between the constant temperature operation and the constant temperature operation, so that the temperature increase operation time can only be a very small portion of the entire device's operating time.

Therefore, in the case of a test device that it can be operated continuously and most of the operation is constant temperature operation, only the first refrigerator with the performance capable of treating only the heat load inside the chamber is operated, so that the wasted energy can be significantly reduced. This means that the heat emitted to the outside of the test device can be significantly reduced, so that it is possible to effectively prevent a heat island phenomenon in a test room where many chambers are installed.

According to the present example, it is possible to minimize the performance of the refrigerator required for always-on running within the range capable of treating the heat load inside the chamber. Therefore, it is possible to significantly reduce the energy inefficiently wasted in always-on running, i.e. constant temperature operation. That is, the waste of energy for driving the refrigerator can be reduced.

Furthermore, in the constant temperature operation, the energy excessively removed from the chamber circulating air is compensated through the heater, where according to the present example, energy waste due to heater driving can be reduced by minimizing the removed energy.

In addition, according to the present example, heat discharged to the outside of the chamber can be reduced, so that the heat island phenomenon can be alleviated.

According to the present example, in a test chamber where long-term temperature maintenance is performed, a low-capacity first refrigerator is driven under a constantly operating temperature maintenance condition (constant temperature operation), and a high-capacity second refrigerator is driven only under a temporary temperature change condition (cooling operation), whereby it is possible to significantly reduce the energy consumed in the test chamber.

### Industrial Applicability

It is described in the Detailed Description of Invention.

## Claims

1. A cycling test device, comprising:
a first refrigerator having a cooling capacity for maintaining a temperature in a chamber at a constant temperature in consideration of a heat load in the chamber;
a second refrigerator provided separately from the first refrigerator and having a cooling capacity greater than the cooling capacity of the first refrigerator, to lower the temperature in the chamber; and
a control part controlling the first refrigerator to be driven in constant temperature operation for maintaining the temperature in the chamber at the constant temperature, and controlling the second refrigerator to be driven only in cooling operation for lowering the temperature in the chamber.

2. The cycling test device according to claim 1, **characterized in that**
the first refrigerator and the second refrigerator comprise compressors and evaporators, which are separated from each other, respectively, and a refrigerant compression capacity of the compressor (first compressor) in the first refrigerator is greater than a refrigerant compression capacity of the compressor (second compressor) in the second refrigerator.

3. The cycling test device according to claim 2, **characterized in that**
the chamber comprises a test space for accommodating and testing a battery, and a circulation duct in which the air discharged from the test space is resupplied to the test space is provided.

4. The cycling test device according to claim 3, **characterized by** comprising
a housing having a first case forming a plurality of partition walls forming the test space, and a second case partitioned from the first case, wherein the circulation duct is provided between the first case and the second case.

5. The cycling test device according to claim 3, **characterized in that**
the evaporator (first evaporator) of the first refrigerator and the evaporator (second evaporator) of the second refrigerator are each provided on the circulation duct.

6. The cycling test device according to claim 5, **characterized in that**
the first evaporator and the second evaporator are sequentially disposed side by side in the flow direction of air.

7. The cycling test device according to claim 5, **characterized by** comprising
one or more temperature sensors for measuring a temperature in the test space, wherein the control part controls driving of the first refrigerator and the second refrigerator by distinguishing the constant temperature operation and the cooling operation based on the set temperature and the temperature sensed by the temperature sensor.

8. The cycling test device according to claim 7, **characterized in that**
the control part controls the second refrigerator to be driven only in the cooling operation.

9. The cycling test device according to claim 7, **characterized in that**
the control part controls the first refrigerator to be driven constantly, or to be driven when the temperature in the chamber reaches the set temperature for performing the constant temperature operation.

10. The cycling test device according to claim 9, **characterized in that**
in the constant temperature operation, driving of a heater provided so that an output is changed by receiving feedback of the temperature in the chamber is controlled.

11. The cycling test device according to claim 7, **characterized in that**
the first compressor is provided with a constant speed compressor having a compression capacity of 1/2 HP or less, and the second compressor is provided with a constant speed compressor or an inverter-controlled compressor having a compression capacity of 2 HP or more.

12. A cycling test device providing constant temperature operation for maintaining temperatures in a plurality of chambers, respectively, at a constant temperature and cooling operation for lowering temperatures in a plurality of chambers, respectively, **characterized by** comprising:
a plurality of first refrigerators driven upon the constant temperature operation for maintaining the temperature in the chamber at a constant temperature and provided to correspond to the plurality of chambers, respectively; and
a single second refrigerator driven upon the cooling operation for lowering the temperature in the chamber and provided to correspond to the plurality of chambers, wherein
a cooling capacity of the second refrigerator is greater than a cooling capacity of the first refrigerator.

13. The cycling test device according to claim 12, **characterized in that**
only any one of the plurality of chambers is provided to enable the cooling operation to be performed.

14. The cycling test device according to claim 13, **characterized in that**
when the cooling operation is required in two or more chambers of the plurality of chambers, the cooling operation is performed sequentially.

15. The cycling test device according to claim 12, **characterized in that**
the second refrigerator comprises a plurality of second evaporators connected in parallel with the single second refrigerator and provided to correspond to the plurality of chambers, respectively, and the second evaporators are disposed sequentially to correspond one-to-one with evaporators of the first refrigerators.
